Europäisches Patentamt

European Patent Office

Office européen des brevets

(11) Veröffentlichungsnummer: **0 492 060 A1**

# EUROPÄISCHE PATENTANMELDUNG

(21) Anmeldenummer: **91115482.1**

(22) Anmeldetag: **12.09.91**

(51) Int. Cl.⁵: **C25D 1/08**, G03F 7/12

(30) Priorität: **28.12.90 DE 4042125**

(43) Veröffentlichungstag der Anmeldung:
**01.07.92 Patentblatt 92/27**

(84) Benannte Vertragsstaaten:
**CH DE ES FR GB IT LI NL**

(71) Anmelder: **MAXS AG**
**Edisriederstrasse 106**
**CH-6072 Sachseln(CH)**

(72) Erfinder: **Maner, Asim, Dr.**
**Obermattli 17**
**CH-6064 Kerns(CH)**

(74) Vertreter: **Patentanwälte Grünecker,**
**Kinkeldey, Stockmair & Partner**
**Maximilianstrasse 58**
**W-8000 München 22(DE)**

(54) **Verfahren zum Herstellen eines Mikroöffnungen aufweisenden, verstärkten flachen Gegenstandes.**

(57) Es wird ein Verfahren zum Herstellen eines Mikroöffnungen aufweisenden, verstärkten flachen Gegenstandes beschrieben, wobei auf eine Grundschicht wenigstens eine Verstärkungsschicht aufgebracht wird. Um ein derartiges Verfahren einfacher und kostengünstiger durchführen zu können, wird vorgeschlagen, eine vorgefertigte Grundschicht beidseitig mit einem strahlungsempfindlichen Resist derart zu beschichten, daß der Resist die Mikroöffnungen ausfüllt, die mit Resist versehene Grundschicht von einer Seite her derart zu bestrahlen, daß die Strahlung den Resist in den Mikroöffnungen durchdringt, den Resist an den mit der Verstärkungsschicht zu versehenen Bereichen der Grundschicht zu entfernen, die Verstärkungsschicht aufzubringen und anschließend den verbleibenden Resist zu entfernen.

FIG.1

Die Erfindung bezieht sich auf ein Verfahren zum Herstellen eines Mikroöffnungen aufweisenden, verstärkten, flachen Gegenstandes, der im Oberbegriff von Anspruch 1 erläuterten Art.

Mikroöffnungen aufweisende, flache Gegenstände haben in der Technik eine breite Anwendung. Beispiele solcher Gegenstände sind Lochblenden, Schattenmasken für Fernsehgeräte, Kodierscheiben, Scherfolien für Trockenrasierer, Bedampfungsmasken für Halbleiter, Taktscheiben und strukturierte Scheiben für Mikrosensoren. Eine wichtige Gattung umfaßt Filter, Siebe und Gitter, die zur Filtration, Siebung, Trennung, Klassierung, Sichtung, Prüfung, Messung und zum Bedrucken verwendet werden. Bei der Herstellung dieser Gegenstände ist vielfach erwünscht, gleichmäßige und möglichst kleine Mikroöffnungen, die Abmessungen zwischen einigen Hundert und Wenigen Mikrometern besitzen, in einer möglichst großen Anzahl pro Flächeneinheit zu erzeugen. Zur Herstellung dieser Gegenstände werden größtenteils lithographische Verfahren in Kombination mit der Galvanoformung oder Ätztechnik eingesetzt. Gemeinsames Merkmal und ein Nachteil der meisten verfügbaren Herstellungsverfahren ist, daß in der Regel mit abnehmenden Abmessungen der Mikroöffnungen die Dicke des flachen Gegenstandes ebenfalls klein gewählt werden muß, wodurch der Gegenstand in vielen Fällen nicht stabil genug hergestellt werden kann.

Um diese Nachteile zu beheben, wurden bereits verschiedene Verfahren vorgeschlagen, um eine konventionell hergestellte, mit Mikroöffnungen versehene Grundschicht nachträglich durch das Aufbringen einer weiteren Schicht zu verstärken. Ein derartiges Verfahren ist beispielsweise aus der DE-OS 2829529 bekannt. Bei diesem Verfahren wird auf elektrisch leitende Bereiche einer Matrize unter Aussparung der die spätere Mikroöffnung bildenden, elektrisch nicht leitenden Bereiche, eine Grundschicht aufgetragen. Dabei werden die Abmessungen der elektrisch nicht leitenden Bereich größer gewählt als die gewünschten Abmessungen der Sieböffnungen, wobei ein "Zuwachsen" der Sieböffnungen beim Abscheiden weiterer Verstärkungsschichten auf die Grundschicht eingerechnet wird. Trotzdem ist zum endgültigen Fertigstellen des Gegenstandes nach dem Aufbringen der Verstärkungsschicht ein Ätzvorgang erforderlich, um die Sieböffnungen auf die gewünschte Breite freizulegen. Um das Material der Verstärkungsschicht gegen den Angriff des Ätzmediums zu schützen, wird auf der der Grundschicht gegenüberliegenden Oberfläche des Gegenstandes eine Ätzmaske aufgebracht, die die Bereiche der Sieböffnungen freiläßt. Zum Aufbringen der Ätzmaske kann Fotolack verwendet werden, wobei jedoch bei diesem Verfahren eine Belichtung durch eine Belichtungsmaske erfolgen muß, deren strahlenddurchlässige Bereiche ganz exakt auf die Mikroöffnungen ausgerichtet werden müssen. Das bekannte Verfahren ist somit relativ kompliziert und zeitaufwendig.

In einem weiteren Ausführungsbeispiel der DE-OS 2829529 wird vorgeschlagen, das auf die Matrize im Bereich der Mikroöffnungen aufzubringende Isoliermaterial mit einer die spätere Siebdicke übersteigenden Stärke aufzutragen, so daß ein Seitenwachstum im Bereich der Mikroöffnungen durch das Isoliermaterial verhindert wird. Der gleiche Gedanke liegt der DE-OS 1496730 zugrunde. Derartig weit über die Oberfläche der Matrize vorstehende Isoliermaterialien sind jedoch äußerst anfällig gegen Beschädigung.

In der EP-A 252545 wird vorgeschlagen, beim Aufbringen einer Verstärkungsschicht auf eine Grundmaterialschicht beim Herstellen eines Mikroöffnungen aufweisenden, flachen Gegenstandes durch die Mikroöffnungen eine Strömung zu erzeugen, die ein Abscheiden von Material im Bereich der Mikroöffnungen und damit deren "Zuwachsen" verhindern soll. Abgesehen davon, daß die Strömungserzeugung das Verfahren kompliziert, führt die Strömung auch zur Abrundung der Begrenzungskanten der Mikroöffnungen, was das Einsatzgebiet des damit hergestellten Gegenstandes stark einschränkt.

Der Erfindung liegt somit die Aufgabe zugrunde, ein Verfahren zum Herstellen eines Mikroöffnungen aufweisenden, verstärkten, flachen Gegenstandes aufzuzeigen, das einfach und kostengünstig durchgeführt werden kann.

Die Aufgabe wird durch die im Anspruch 1 angegebenen Merkmale gelöst.

Beim erfindungsgemäßen Verfahren wird auf einfache Weise erreicht, daß sich Mikroöffnungen beim Aufbringen der Verstärkungsschicht nicht oder nicht wesentlich verkleinern können. Durch das beidseitige Aufbringen des Resists wird erreicht, daß die Grundschicht selbst als Strahlungsmaske verwendet werden kann, so daß keine weitere, genau einzujustierende Strahlungsmaske notwendig ist. Das Aufbringen der Resistschichten bietet keinerlei Schwierigkeiten, da die Verwendung von Resistwerkstoffen zum Aussparen von Teilbereichen beim Ätzen oder beim galvanischen Beschichten beispielsweise bereits aus der DE-PS 3529966 oder der DE-OS 3118335 bekannt ist.

Vorteilhafte Weiterbildungen des erfindungsgemäßen Verfahrens sind den Unteransprüchen 2 bis 9 zu entnehmen.

Ausführungsbeispiele der Erfindung werden nachfolgend anhand der Zeichnungen näher erläutert. Es zeigen:

Fig. 1A bis 1G
Verfahrensschritte beim erfindungsgemäßen Herstellen eines Filtersiebs,

Fig. 2A bis 2E
Verfahrensschritte beim erfindungsgemäßen Herstellen einer Scherfolie, und
Fig. 3A bis 3E
Verfahrensschritte beim erfindungsgemäßen Herstellen eines Optikgitters.

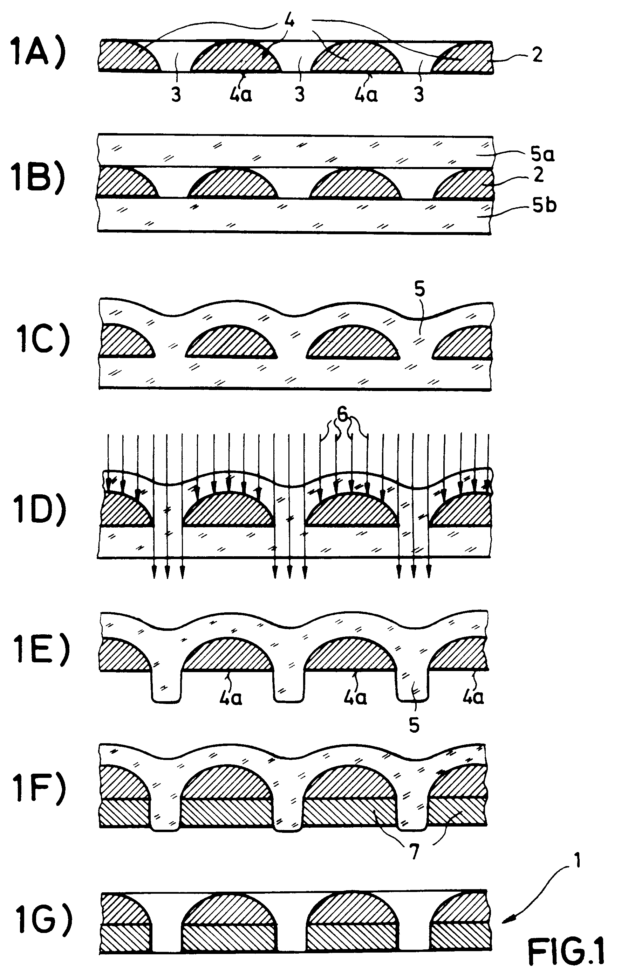

Wie Fig. 1 zeigt, wird bei der Herstellung eines in Fig. 1G dargestellten Filtersiebes 1 zunächst eine in Fig. 1A gezeigte Grundschicht 2 auf herkömmliche Weise, beispielsweise durch galvanisches Abscheiden auf eine Matrize, hergestellt. Die Grundschicht 2 weist bereits die Form des fertigen Filtersiebes 1 mit Mikroöffnungen 3 und dazwischenliegenden Materialstegen 4, mit einer der endgültigen Weite entsprechenden Weite der Mikroöffnungen 3 auf, ist jedoch dünner. Wie Fig. 1B zeigt, wird die Grundschicht 2 anschließend zwischen zwei Lagen 5a und 5b eines handelsüblichen, Negativ-Fotoresists 5 gelegt und in den Walzspalt zwischen zwei auf 110° c erhitzten und gummibeschichteten Walzen eingeführt und unter einer Druckbelastung von 5 bar gewalzt. Nach diesem Verfahrensschritt ist die Grundschicht 2, wie Fig. 1C zeigt, allseitig, d. h. auch in den Mikroöffnungen 3, von Fotoresist 5 umschlossen. Danach wird auf eine Seite, wie Fig. 1D zeigt, mit gerichteten UV-Strahlen 6 bestrahlt, die den Fotoresist 5 an allen, nicht durch die Stege 4 der als Belichtungsmaske wirkenden Grundschicht 2 abgeschatteten Bereichen durchstrahlt. Die nicht durchstrahlten, abgeschatteten Bereiche des Fotoresists 5 unterhalb der Stege 4 werden danach in einer Entwicklerlösung aus 1%igem Natriumcarbonat bei 35° C durch Sprühentwicklung abgelöst. Wie Fig. 1E zeigt, liegen nach dem Entwickeln die Unterseiten 4a der Stege 4 der Grundschicht 2 nach außen frei, während der in die Mikroöffnungen 3 eingedrungene Fotoresist 5 etwas über die freiliegenden Flächen 4a vorsteht. Anschließend wird auf die freiliegenden Flächen 4a in einem Galvanikbad eine Verstärkungsschicht 7 abgeschieden. Nach dem Abscheiden wird der verbleibende Resist 5 durch 3%ige Natronlauge bei 50° C entfernt.

Im vorliegenden Ausführungsbeispiel besteht die Grundschicht 2 aus galvanisch abgeschiedenem Nickel mit einer Dicke von 100$\mu$m. Die Mikroöffnungen 3 haben im Bereich der Oberflächen 4a der Stege 4 eine kleinste Weite von 100$\mu$m und verbreitern sich in Richtung auf die der Oberfläche 4a abgewandten Oberfläche der Grundschicht 2. Die Stege 4 zwischen den Mikroöffnungen 3 sind 300$\mu$m breit. Zum Beschichten werden zwei Folien eines handelsüblichen Fotorestists von je 100$\mu$m Dicke verwendet. Die Verstärkungsschicht 7 besteht ebenfalls aus bei 55° C galvanisch abgeschiedenem Nickel und hat eine Dicke von 80 $\mu$m, so daß das erfindungsgemäß hergestellte Filtersieb eine Gesamtdicke von 180$\mu$m aufweist, wobei die ursprünglich erzielte Größe der Mikroöffnungen 3 nicht verändert wurde. Durch Über- oder Unterbelichten des Fotoresists läßt sich erreichen, daß die Stege schrägverlaufende Seitenwände erhalten. Die sich in der Verstärkungsschicht ausbildenden Mikroöffnungen verjüngen sich dann zu einer Seite hin, was einer Verstopfungsgefahr des Siebes bei Verwendung als Filter entgegenwirkt.

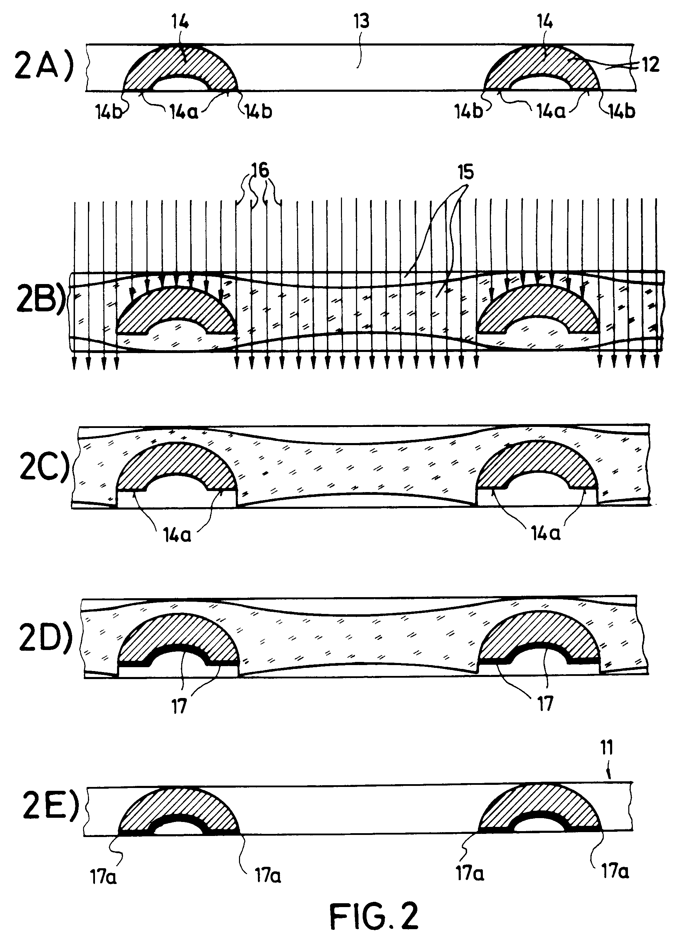

Fig. 2 beschreibt die Herstellungsschritte beim Herstellen einer in Fig. 2E gezeigten, verstärkten Scherfolie 11 für Trockenrasierer. Wiederum wird zunächste eine Grundschicht 12 in Form und Abmessung einer herkömmlichen Scherfolie galvanisch hergestellt, wobei die Grundschicht 12 Öffnungen 13 mit einem dem Enddurchmesser von Öffnungen für Scherfolien entsprechenden Durchmesser und Stege 14 aufweist, die an einer ihrer Oberflächen 14a eben sind und Scherkanten 14b bilden. Das erfindungsgemäße Verfahren kann eingesetzt werden, um die einem starken Verschleiß ausgesetzten Oberflächen 14a und Scherkanten 14b zu verstärken. Zu diesem Zweck wird die Grundschicht 12 in ein Tauchbad aus flüssigem, negativ arbeitendem Fotoresist eingetaucht, herausgezogen und der anhaftende und durch seine Oberflächenspannung in den Öffnungen 13 gehaltene Film des Fotoresists 15 durch Erwärmung mit einem Infrarotstrahler auf 90° C getrocknet. Das Gebilde wird, wie aus Fig. 2B ersichtlich, wiederum mit gerichteten UV-Strahlen 16 bestrahlt, wobei die Stege 14 als Belichtungsmaske wirken, die eine Belichtung der unterhalb der Oberflächen 14a liegenden Resistbereiche verhindern, während der Resist in den Öffnungen 13 vollständig durchstrahlt wird. Anschließend werden die nicht bestrahlten Bereiche des Negativ-Fotoresists 15 entfernt, so daß die Oberflächen 14a der Stege nach außen hin freiliegen. Gleichzeitig bleiben jedoch diejenigen Bereiche des Resists stehen, die sich direkt neben dem durch die Scherkanten 14b gebildeten Strahlungsschatten befunden haben. Danach wird eine Verstärkungsschicht 17 aus einem verschleißfesten Material galvanisch aufgebracht. Diese Verstärkungsschicht 17 endet durch den genau definierten Strahlungsschatten der Scherkanten 14b direkt in Verlängerung der Scherkanten 14b unter Bildung einer exakt definierten, neuen und verschleißfesteren Scherkante 17a. Darüberhinaus erhöht die Verstärkungsschicht 17 die Verschleißfestigkeit auch im Bereich der nach unten weisenden, und vom Messerblock des Trockenrasierers überstrichenen Oberfläche 14a der Stege 14.

Die Grundschicht 12 besteht aus Nickel und weist eine für Scherfolien typische Dicke von 60$\mu$m auf. Die Verstärkungsschicht 17 besteht aus einer Zinn-Nickel-Legierung und hat eine Dicke von 8$\mu$m.

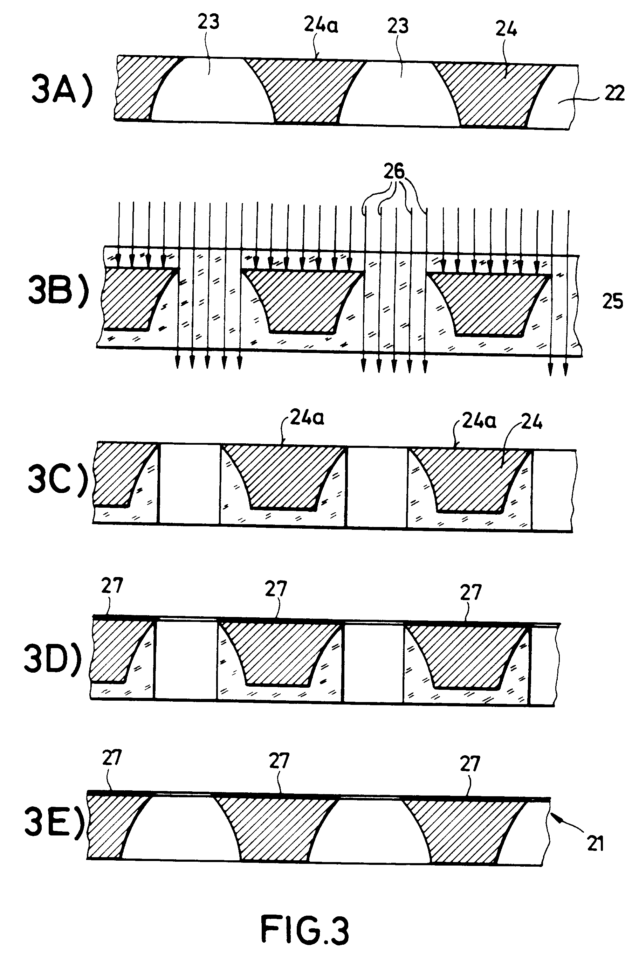

Fig. 3 zeigt ein Ausführungsbeispiel des erfindungsgemäßen Verfahrens zum Herstellen eines in Fig. 3E gezeigten Optikgitters 21. Wiederum wird zunächst eine Grundschicht 22 auf herkömmliche Weise, in diesem Fall durch naßchemisches Ätzen, hergestellt. Die Grundschicht 22 weist ebenfalls Öffnungen 23 und Stege 24 auf, deren Weite bereits der gewünschten Weite im fertigen Optikgitter 21 entspricht. Die Grundschicht 22 wird durch das Eintauchen in ein Resistbad allseitig, einschließlich der Öffnungen 23 mit einem Fotoresist 25 bedeckt, der im vorliegenden Falle positiv arbeitet. Deshalb wird eine gerichtete UV-Strahlung 26 derart aufgebracht, daß die zu verstärkende Oberfläche 24a der Strahlung ausgesetzt ist; die Begrenzungswände der Mikroöffnungen 23, bedingt durch deren Form, und die der Oberfläche 24a gegenüberliegende Oberfläche im Strahlenschatten liegen. Danach werden die belichteten Bereiche des positiv wirkenden Resists 25 entwickelt, so daß, wie Fig. 3C zeigt, die zu verstärkenden Oberflächen 24a freiliegen. Auf diese Oberflächen wird danach eine Verstärkungsschicht 27 aufgebracht, und anschließend der verbleibende Resist entfernt. Selbstverständlich kann auch in diesem Ausführungsbeispiel nach Fig. 3 ein negativ wirkender Resist verwendet werden; die Bestrahlung müßte dann jedoch von der den Oberflächen 24a abgewandten Seite her erfolgen.

In Abwandlung der beschriebenen und gezeichneten Ausführungsbeispiele können die anhand der einzelnen Figuren gezeichneten Einzelheiten untereinander ausgetauscht werden. So kann beispielsweise auch die Scherfolie nach Fig. 2 durch Aufwalzen von Resistfolien unter Wärmeeinwirkung mit dem Resist beschichtet werden bzw. das Filtersieb nach Fig. 1 in ein Resistbad getaucht werden. Mit dem erfindungsgemäßen Verfahren können weiterhin alle der in der Einleitung genannten, mit Mikroöffnungen versehenen Gegenstände verstärkt werden. Falls gewünscht, können nach einmaliger Beschichtung mit dem Fotoresist, der Belichtung und der Entwicklung zwei oder noch mehr Verstärkungsschichten aufgebracht werden, die bei Bedarf auch aus unterschiedlichen Materialien bestehen können. Wird eine insgesamt möglichst große Dicke der Verstärkungsschicht erwünscht, so kann der ganze Prozeß nach der Aufbringung einer Verstärkungsschicht noch einmal oder ggf. mehrfach wiederholt werden, um eine zweite Verstärkungsschicht oder weitere Verstärkungsschichtenn aufzubringen. Statt des Fotoresists können beispielsweise auch röntgenstrahlenempfindliche Resistmaterialien wie beispielsweise Polymethylmethacrylat (PMMA) verwendet werden, wobei in diesem Fall zur Bestrahlung gerichtete Röntgenstrahlen aus einem Synchrontron eingesetzt werden können. Das Aufbringen der Verstärkungsschicht kann außer durch eine galvanische auch durch eine chemisch reduktive Metallabscheidung in einem Bad erfolgen. Schließlich kann die Verstärkungsschicht auch unter Vakuum in einem Bedampfungs- oder Besputterungsprozeß gebildet werden. Außer den beschriebenen Grundschichten aus Metall können auch nicht leitende Grundschichtmaterialien mit dem erfindungsemäßen Verfahren verstärkt werden. Zu diesem Zweck wird die Grundschicht vor der Beschichtung mit dem Resist an ihrer gesamten Oberfläche oder in Teilbereichen direkt oder nach vorangegangener chemischer Aktivierung metallisiert.

**Patentansprüche**

1. Verfahren zum Herstellen eines Mikroöffnungen aufweisenden, verstärkten, flachen Gegenstandes, wobei auf eine Grundschicht wenigstens eine Verstärkungsschicht aufgebracht wird, **dadurch gekennzeichnet**, daß eine vorgefertigte Grundschicht beidseitig mit einem strahlungsempfindlichen Resist derart beschichtet wird, daß der Resist die Mikroöffnungen ausfüllt, daß die mit Resist versehene Grundschicht einseitig bestrahlt wird, wobei die Strahlung den Resist in den Mikroöffnungen durchdringt, daß der Resist an den mit der Verstärkungsschicht zu versehenen Oberflächenbereichen der Grundschicht entfernt wird, daß die Verstärkungsschicht aufgebracht und daß anschließend der verbleibende Resist entfernt wird.

2. Verfahren nach Anspruch 1, **dadurch gekennzeichnet**, daß auf eine erste Verstärkungsschicht eine zweite Verstärkungsschicht aufgebracht wird.

3. Verfahren nach Anspruch 1 oder 2, **dadurch gekennzeichnet**, daß die Beschichtung mit dem Resist im Vakuum erfolgt.

4. Verfahren nach einem der Ansprüche 1 bis 3, **dadurch gekennzeichnet**, daß als Strahlung gerichtete UV-Strahlen oder Röntgenstrahlen verwendet werden.

5. Verfahren nach einem der Ansprüche 1 bis 4, **dadurch gekennzeichnet**, daß die Verstärkungsschicht durch galvanische oder chemisch-reduktive Metallabscheidung in einem Bad gebildet wird.

6. Verfahren nach einem der Ansprüche 1 bis 4, **dadurch gekennzeichnet**, daß die Verstärkungsschicht durch einen Bedampfungs- oder Beschutterungsprozeß in einer Vakummapparatur gebildet wird.

7. Verfahren nach Anspruch 5, **dadurch gekennzeichnet**, daß elektrisch nicht leitende Grundschichten zum Zwecke der galvanischen oder chemisch-reduktiven Metallabscheidung in einem Bad vor der Beschichtung mit dem Resist an ihrer ganzen Oberfläche oder in Teilbereichen der Oberfläche direkt oder nach vorangehender chemischer Aktivierung metallisiert werden.

8. Verfahren nach einem der Ansprüche 1 bis 7, **dadurch gekennzeichnet**, daß die Grundschicht zum Beschichten mit dem Resist zwischen zwei Lagen einer Resistfolie gelegt und der Resist durch Anwendung von Druck und Wärme beidseitig auf die Grundschicht aufgebracht und in die Mikroöffnung eingedrückt wird.

9. Verfahren nach einem der Ansprüche 1 bis 7, **dadurch gekennzeichnet**, daß die Grundschicht zum Beschichten mit dem Resist in ein Bad aus flüssigem Resist getaucht und die Resistbeschichtung unter Wärmeeinwirkung getrocknet wird.

FIG.1

FIG. 2

FIG.3

Europäisches
Patentamt

**EUROPÄISCHER RECHERCHENBERICHT**

Nummer der Anmeldung

EP    91 11 5482

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 057 268 (IBM)<br>* Abbildung 4 *<br>--- | 1 | C25D1/08<br>G03F7/12 |
| A,D | DE-A-1 496 730 (BALCO-FILTER)<br>* das ganze Dokument *<br>--- | 1 | |
| A,D | DE-A-3 118 335 (SIEMENS A.G.)<br>* das ganze Dokument *<br><br>----- | 1 | |
| | | | **RECHERCHIERTE SACHGEBIETE (Int. Cl.5)**<br><br>C25D<br>G03F |

Der vorliegende Recherchenbericht wurde für alle Patentansprüche erstellt

| Recherchenort | Abschlußdatum der Recherche | Prüfer |
|---|---|---|
| DEN HAAG | 01 APRIL 1992 | RASSCHAERT A. |